# EUROPEAN PATENT APPLICATION

(11) **EP 1 848 044 A2**
(43) Date of publication of application: **24.10.2007**
(21) Application number: 07008012.2
(22) Date of filing: 19.04.2007
(51) Int. Cl.: H01L 33/00

(54) **Semiconductor device and seconductor device fabrication method**

(30) Priority: 19.04.2006 JP 2006115725
(71) Applicant: SHINKO ELECTRIC INDUSTRIES CO., LTD., Nagano-shi, Nagano 381-2287 (JP)
(72) Inventor: Higashi, Mitsutoshi, Nagano-shi Nagano, 381-2287 (JP); Murayama, Kei, Nagano-shi Nagano, 381-2287 (JP); Shiraishi, Akinori, Nagano-shi Nagano, 381-2287 (JP); Taguchi, Yuichi, Nagano-shi Nagano, 381-2287 (JP)
(74) Representative: Zimmermann, Gerd Heinrich

(57) **Abstract**

There is provided a semiconductor device in which a light emitting element (107) is mounted on a substrate (101, 101a), having a bonding wire (104) which is connected to the light emitting element, and a through electrode (103) which is connected to the bonding wire and is formed in such a manner as to pass through the substrate at a position lying directly below a connecting portion with the bonding wire.

## Description

This application claims priority to Japanese Patent Application No. 2006-115725, filed April 19, 2006, in the Japanese Patent Office. The priority application is incorporated by reference in its entirety.

The present disclosure generally relates to a semiconductor device in which a light emitting element is mounted on a substrate and a fabrication method of the semiconductor device. Specifically, it relates to a semiconductor device and a method for fabrication a semiconductor device.

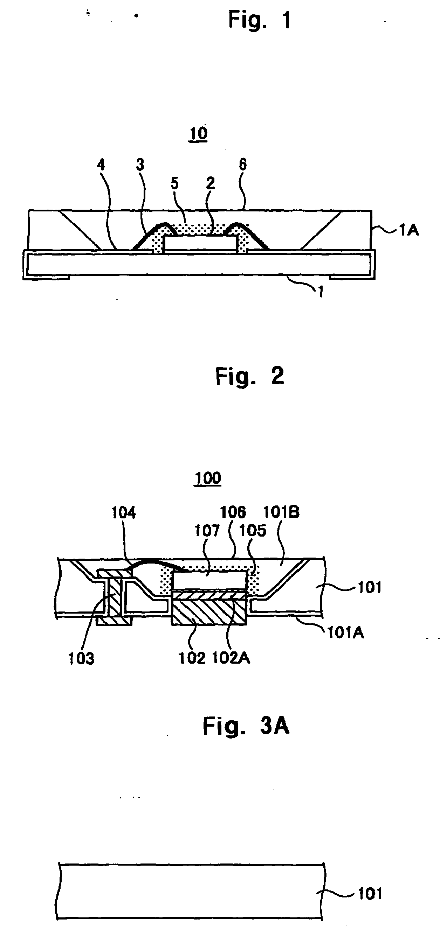

Semiconductor devices of various shapes have been proposed for semiconductor devices in which a light emitting element such as an LED is mounted on a substrate. For example, Fig. 1 is a drawing which exemplarily shows one of those semiconductor devices which have been proposed in the related-art.

Referring to Fig. 1, in a semiconductor device 10, a light emitting element 2 made up of an LED coated with a fluorescent material 5 is mounted on a substrate made of, for example, a ceramic. In addition, a wall portion 1A is formed on the substrate 1 in such a manner as to surround the light emitting element 2 so as to define a cavity 6, so that the light emitting element 2 is mounted in such a manner as to be accommodated in the cavity 6. Additionally, a patterned wiring 4 is formed on the substrate 1, and the wiring 4 and the light emitting element 5 are electrically connected to each other by a wire 3. (See, e.g., Japanese Patent Unexamined Publication No. 2005-277380.)

In the construction shown in Fig. 1, however, the light emitting element mounted on the ceramic substrate is constructed so as to be connected to the wiring patterned on the ceramic substrate through wire bonding. Consequently, a space needs to be secured on the substrate to pattern and route the wiring that is to be connected to the wire. Because of this, there has been caused a problem that the miniaturization of the semiconductor device becomes difficult.

In addition, in the semiconductor device, the routing of the wiring that is connected to the light emitting element gets complex, and hence there have been caused further problems that the resistance of the wiring is increased and that the reliability of the wiring is decreased.

In light of the above, the semiconductor device according to independent claim 1, and the method for fabricating a semiconductor device according to independent claim 12 are provided.
Further advantages, features, aspects and details of the invention are evident from the dependent claims, the description and the drawings.
Embodiments of the present invention provide a semiconductor device.

More specifically, embodiments of the present invention provide a semiconductor device having a light emitting element mounted thereon which can be miniaturized and which has superior reliability and a semiconductor device fabrication method for fabricating the semiconductor device.

According to a first aspect of the invention, there is provided a semiconductor device in which a light emitting element is mounted on a substrate, having a bonding wire which is connected to the light emitting element, and a through electrode which is connected to the bonding wire and is formed in such a manner as to pass through the substrate at a position lying directly below a connecting portion with the bonding wire.

This semiconductor device is characteristic in that the semiconductor device can be miniaturized and has superior reliability.

In addition, in the event that the light emitting element is made up of an LED, the LED being covered with a resin which contains a fluorescent material, the color of light emitted from the light emitting element can be controlled.

Additionally, in the event that the substrate is made of a silicon, the flatness of the substrate can be improved, and the working accuracy of the substrate is also improved.

In addition, in the event that the bonding wire and the through electrode are each provided two or more, an increase in the number of wiring systems that are to be connected to the light emitting element can be facilitated.

Additionally, in the event that the semiconductor device has an additional through electrode which is connected to the light emitting element on an opposite side to a side where the bonding wire is connected and is formed in such a manner as to pass through the substrate at a position lying directly below the light emitting element, the routing construction of the wiring that is connected to the light emitting element becomes simplified.

In addition, the additional through electrode may be formed two or more.

Additionally, in the event that the lengths of the through electrode and the additional through electrodes are the same, the formation of the through electrode and the additional through electrode is facilitated.

In the event that the light emitting element is mounted in a recessed portion which is formed on the substrate, the formation of a reflecting portion of the light emitting element is facilitated.

In addition, in the event that the semiconductor device has a flat plate-like cover which is joined to a perimeter of the recessed portion, the light emitting element can be protected.

According to a second aspect of the invention, there is provided a method for fabricating a semiconductor device in which a light emitting element is mounted on a substrate, having an electrode forming step of forming a through electrode which passes through the substrate, a placing step of placing the light emitting element on the substrate, and a wiring step for connecting the light emitting element with a side of the through electrode which corresponds to the light emitting element through wire bonding.

In the fabrication method, the semiconductor device can be fabricated which can be miniaturized and which has superior reliability.

According to the invention, there can be provided the semiconductor device which can be miniaturized and which has superior reliability and the semiconductor device fabrication method for fabricating the semiconductor device.
Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, a computer programmed by appropriate software, by any combination thereof or in any other manner.
Other features and advantages may be apparent from the following detailed description, the accompanying drawings and the claims. The invention will be better understood by reference to the following description of embodiments taken in conjunction with the accompanying drawings, wherein:

Fig. 1 is a drawing which shows a related-art semiconductor device.
Fig. 2 is a drawing which shows a semiconductor device according to a first embodiment.
Fig. 3A is a (first) drawing which shows a fabrication method of the semiconductor device shown in Fig. 2.
Fig. 3B is a (second) drawing which shows the fabrication method of the semiconductor device shown in Fig. 2.
Fig. 3C is a (third) drawing which shows the fabrication method of the semiconductor device shown in Fig. 2.
Fig. 3D is a (fourth) drawing which shows the fabrication method of the semiconductor device shown in Fig. 2.
Fig. 3E is a (fifth) drawing which shows the fabrication method of the semiconductor device shown in Fig. 2.
Fig. 3F is a (sixth) drawing which shows the fabrication method of the semiconductor device shown in Fig. 2.
Fig. 3G is a (seventh) drawing which shows the fabrication method of the semiconductor device shown in Fig. 2.
Fig. 3H is an (eighth) drawing which shows the fabrication method of the semiconductor device shown in Fig. 2.
Fig. 3I is a (ninth) drawing which shows the fabrication method of the semiconductor device shown in Fig. 2.
Fig. 3J is a (tenth) drawing which shows the fabrication method of the semiconductor device shown in Fig. 2.
Fig. 3K is an (eleventh) drawing which shows the fabrication method of the semiconductor device shown in Fig. 2.
Fig. 3L is a (twelfth) drawing which shows the fabrication method of the semiconductor device shown in Fig. 2.
Fig. 4 is a drawing which shows a semiconductor device according to a second embodiment.
Fig. 5 is a drawing which shows a semiconductor device according to a third embodiment.
Fig. 6 is a drawing which shows a semiconductor device according to a fourth embodiment.
Fig. 7 is a drawing which shows a semiconductor device according to a fifth embodiment.
Fig. 8 is a drawing which shows a semiconductor device according to a sixth embodiment.
Fig. 9 is a drawing which shows a semiconductor device according to a seventh embodiment.

A semiconductor device according to the invention is a semiconductor device in which a light emitting element is mounted on a substrate, having a bonding wire which is connected to the light emitting element and a through electrode which is connected to the bonding wire and is formed in such a manner as to pass through the substrate at a position lying directly below a connecting portion with the bonding wire.

With a related-art semiconductor device, since a wiring which is patterned on a substrate and a light emitting element are constructed to be connected with each other through wire bonding, there is caused a need to secure a space on the substrate to pattern and route the wiring, this causing the problem that the miniaturization of the semiconductor device becomes difficult.
In addition, with the semiconductor device, the routing of the wiring that is connected to the light emitting element becomes complex, resulting in concerns that the resistance of the wiring is increased and that the reliability of the wiring is decreased.

On the other hand, the semiconductor device according to the invention has the through electrode which is connected to the bonding wire which is connected to the light emitting element and is formed in such a manner as to pass through the substrate at the portion lying directly below the connecting portion with the bonding wire.

Because of this, the necessity of patterning and routing the wiring on the substrate so as to be connected to the light emitting element can be obviated, thereby making it possible to miniaturize the semiconductor device. In addition, since the construction of the semiconductor device is simplified, the semiconductor device can be configured which has superior reliability.

In addition, as this occurs, the substrate on which the light emitting element is mounted and in which the through electrode is formed in such a manner as to pass therethrough is preferably made of a silicon. As this occurs, the flatness of the substrate is improved and the working accuracy of the substrate is also improved.

Next, a configuration example of the semiconductor device and a fabrication method example for fabricating the semiconductor device will be described based on the drawings.

Fig. 2 is a sectional view which shows exemplarily a semiconductor device 100 according to a first embodiment of the invention. Referring to Fig. 2, in the semiconductor device 100 according to this embodiment, a light emitting element 107 which is made up of, for example, an LED is mounted on a substrate 101 which is made of, for example, a silicon. A resin 105 containing a fluorescent material is coated on the light emitting element 107. The color of light emitted from the light emitting element and the color light emitted from of the fluorescent material can be mixed for use by so coating the resin 105, thereby making it possible to control the color of light emitted from the semiconductor device in various ways. In addition, for example, a silicon based or epoxy based resin layer 106 is formed in such a manner as to cover the resin 105 for protection of the resin 105. Additionally, the fluorescent material may be mixed into the whole of the resin layer 106.

A recessed portion (a cavity) 101B is formed on the substrate 101 for mounting therein the light emitting element 107, and the light emitting element 107 is mounted at a bottom portion of the recessed portion 101B. In this case, the resin layer 106 is formed in such a manner as to fill the recessed portion 101B. In addition, a through electrode 102 made of, for example, Cu is formed in the bottom portion of the recessed portion 101B in such a manner as to pass through the bottom portion, and a connection layer 102A which is made up of, for example, an Au/Sn layer (with the Au lying on the device side) or an Ag/Cu/Sn layer (with the Ag lying on the device side) is formed on the through electrode 102. The light emitting element 107 is mounted in such a manner as to be connected to the through electrode 102 via the connection layer 102A. Namely, the light emitting element 107 is mounted in such a manner as to connected with the through electrode 102 which is formed in such a manner as to pass through the substrate 101 at a position lying directly below the light emitting element 107.

In addition, the semiconductor device 100 according to this embodiment has a through electrode 103 which is connected to a bonding wire 104 which is connected to the light emitting element 107 and is formed in such a manner as to pass through the substrate 101 at a position lying directly below a connecting portion with the bonding wire 104.

Because of this, with the semiconductor device according to the embodiment, the wiring that is connected to the light emitting element 107 does not have to be patterned and formed on the substrate 101. Because of this, a space on the substrate to route the wiring becomes unnecessary, thereby making it possible to miniaturize the semiconductor device.

In addition, in the case of the semiconductor device 100, a construction is adopted in which the through electrodes 102, 103 are connected to a motherboard or the like, which constitutes a connection object, on their sides which are opposite to respective sides thereof which correspond to the side where the light emitting element 107 is mounted. Namely, in the construction described above, a connection path from the light emitting element 107 to the connection object (the motherboard) of the light emitting element 107 exhibits a low resistance and is constructed simply, resulting in a highly reliable construction.

Additionally, the thickness of a portion of the substrate 101 where the through electrode 103 passes through the substrate 101 is made thicker than the thickness of a portion thereof where the through electrode 102 passes through the substrate 101. In this case, an upper surface (a surface to which the wire 104 is connected) of the light emitting element 107 and an upper surface (a surface to which the wire 104 is connected) of the through electrode 103 can be formed in such a manner as to be substantially level with each other, the connection through wire bonding is facilitated.

On the other hand, in the event that the thickness of the portion of the substrate 101 where the through electrode 103 passes through the substrate 101 and the thickness of the portion of the substrate 101 where the through electrode 12 passes through the substrate 101 are made equal to each other, the lengths of the through electrode 102 and the through electrode 103 become the same, whereby the formation of the through electrode 102 and the through electrode 103 is facilitated (this construction will be described later on).

In addition, with the semiconductor device 100 of this embodiment, since the substrate on which the light emitting element is mounted is made of a silicon, there are provided advantages that the flatness of the substrate is improved and that the working accuracy of the substrate is improved to thereby facilitate fine working. In addition, when the flatness of the substrate is improved, a contact area between the light emitting element and the substrate (the electrode) is increased, whereby there is provided an advantage that the heat dissipation of the light emitting element is improved.
Additionally, since good heat conductivity can be provided by silicon, compared to a sintered material such as ceramics, the efficiency of heat dissipation of the light emitting element is improved.

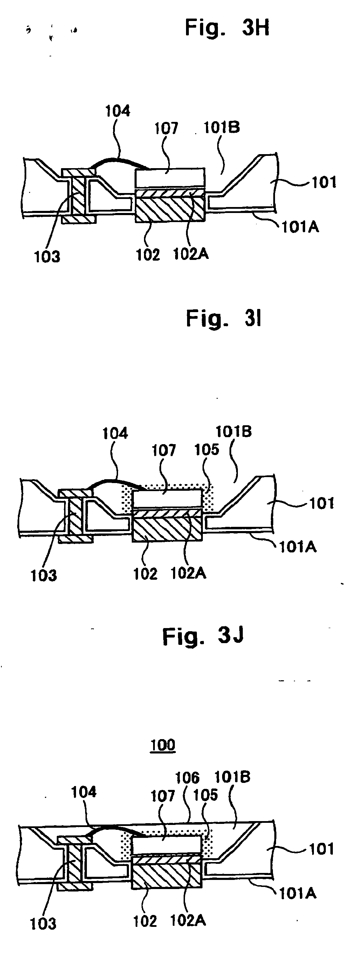

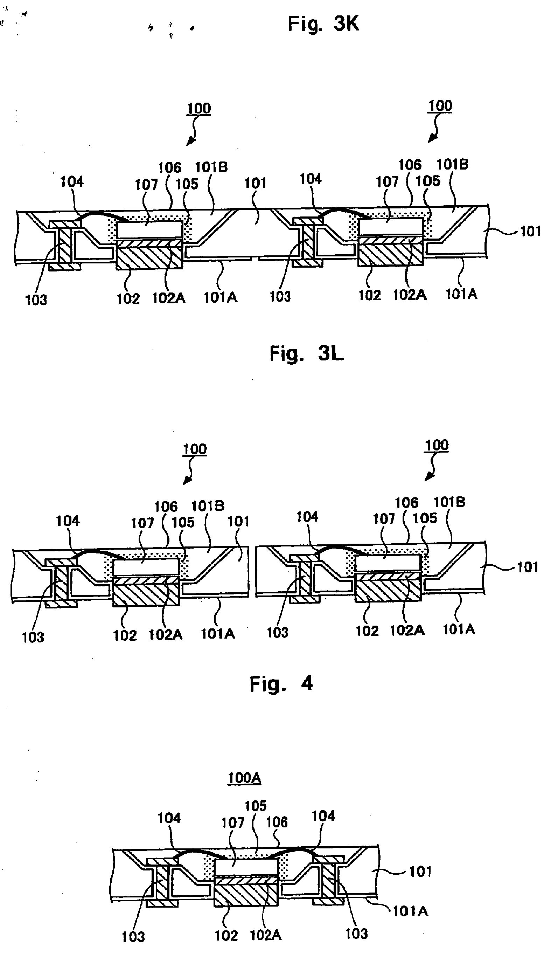

Next, one example of a fabrication method for fabricating the semiconductor device 100 will be described by following a procedure thereof based on Figs. 3A to 3L. In the drawings below, however, like reference numerals will be given to like portions to those that have already been described, so as to omit the repetition of similar descriptions from time to time.

Firstly, in a step shown in Fig. 3A, for example, a substrate 101 (for example, a silicon wafer) which is made of a silicon (Si) is prepared. As required, the substrate may be made thin in advance by grinding.

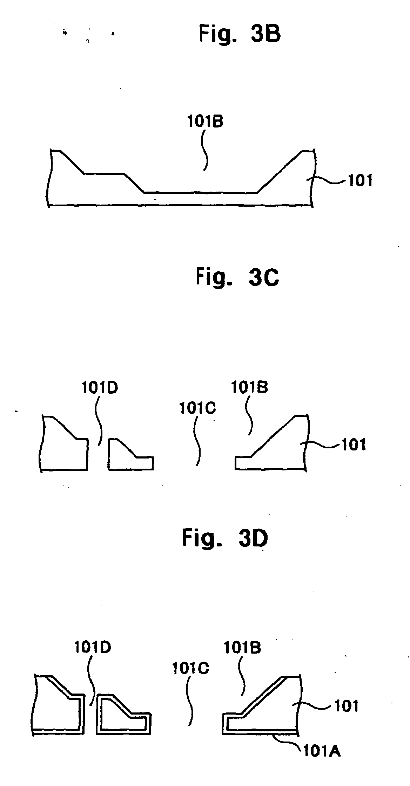

Next, in a step shown in Fig. 3B, the substrate 101 is etched so as to form a pattern, and a recessed portion (a cavity) is formed so that a light light emitting element can be set therein. As this occurs, as has been described before, the recessed portion 101B is preferably formed in such a manner that a portion where the through electrode 103 is formed (a portion where a via hole 101C is formed in the following step shown in Fig. 3C) is made thicker than a portion where a light emitting element 107 is mounted (a portion where a via hole 101D is formed in a step shown in Fig. 3D).

Next, in a step shown in Fig. 3D, an oxide layer (referred to as a silicon oxide layer, or a thermal oxide layer from time to time) 101A is formed on a surface of the substrate 101 including an inner wall surface of the recessed portion 101B and inner wall surfaces of the via holes 101C, 101D by, for example, a thermal CVD process or the like. In addition, in place of the oxide layer 101A, a nitride layer (a silicon nitride layer) may be formed.

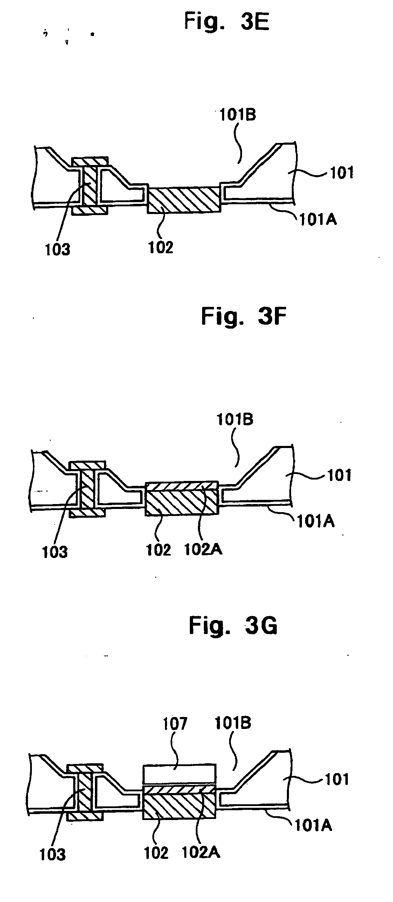

Next, in a step shown in Fig. 3E, through electrodes 102, 103 are formed of Cu in the via holes 101C, 101D, respectively, by a plating process (or a so-called via fill process). In this case, the length of the through electrode 103 becomes longer than the length of the through electrode 102.

Next, in a step shown in Fig. 3F, a connection layer 102A is formed on a side of the through electrode 102 which faces the recessed portion 101B by, for example, a plating process. The connection layer 102A is made up of an Au/Sn layer (with Au lying on a side which is joined to the light emitting element) or an Ag/Cu/Sn layer (with Ag lying on a side which is joined to the light emitting element). In addition, the connection layer 102A may be formed from a conductive adhesive material.

Next, in a step shown in Fig. 3G, the light emitting element 107 and the connection layer 102A are joined together by virtue of thermal contact bonding or reflowing, so that the light emitting element 107 is mounted at a bottom portion of the recessed portion 101B.

Next, in a step shown in Fig. 3H, the light emitting element 107 and a side of the through electrode 103 which corresponds to the light emitting element 107 are electrically connected to each other by virtue of wire bonding. As a result, the light emitting element 107 and the through electrode 103 are connected to each other by means of a wire 104. As this occurs, in the event that the upper surface of the light emitting element 107 and the upper surface of the through electrode 103 are formed on the same plane, the connection by virtue of wire bonding is preferably facilitated.

Next, in a step shown in Fig. 3I, the light emitting element 107 is covered with a resin 105 containing a fluorescent material. As this occurs, while the resin is formed by virtue of, for example, printing or coating by means of a dispenser, the resin 105 may be formed by a ink-jet process or by virtue spraying.

Next, in a step shown in Fig. 3J, a resin layer 106 is formed in such a manner as not only to cover the light emitting element 107 and the resin 105 but also to fill the recessed portion 101B. While the resin layer 106 is formed from a silicon based or epoxy based resin, the invention is not limited thereto. The semiconductor device 100 shown in Fig. 2 can be fabricated in the way that has been described heretofore.

In addition, in fabricating the semiconductor device 100, there may occur a case where a plurality of constructions each corresponding to the semiconductor device 100 are simultaneously formed on a silicon substrate. As this occurs, the silicon substrate is cut apart from one another by virtue of, for example, dicing or the like, so that the semiconductor devices so formed are made to constitute individual semiconductors.

Fig. 3K is a drawing which shows a state where two semiconductor devices 100 are formed on a single substrate 101. Note that while in Fig. 3K, two constructions each corresponding to the semiconductor device are shown, in reality, more or than two semiconductor devices are formed on a single substrate.

The constructions shown in Fig. 3K are cut apart from each other so as to constitute separated individual semiconductor devices as shown in Fig. 3J by dicing the substrate 101.

In addition, the semiconductor device of the invention is not limited to the constructions described above, and hence, the semiconductor device can be changed or modified variously as will be shown below, for example.

Fig. 4 is a drawing which exemplarily shows a semiconductor device 100A according to a second embodiment of the invention. In the drawing, however, like reference numerals will be given to like portions to those which have already been described above so as to omit the repetition of similar descriptions. In addition, portions about which no particular description will be made have the similar constructions to those of the semiconductor device 100 described in the first embodiment and provide the same advantages provided thereby.

Referring to Fig. 4, in a semiconductor device 100A according to this embodiment, two bonding wires 104 and two through electrodes 103 to which the two bonding wires 104 are connected are formed. In this way, the number of such constructions in which the bonding wire and the through electrode to which the bonding wire is connected are combined may be increased as required. As this occurs, the number of wiring systems which are provided to be connected to light emitting elements can be increased.

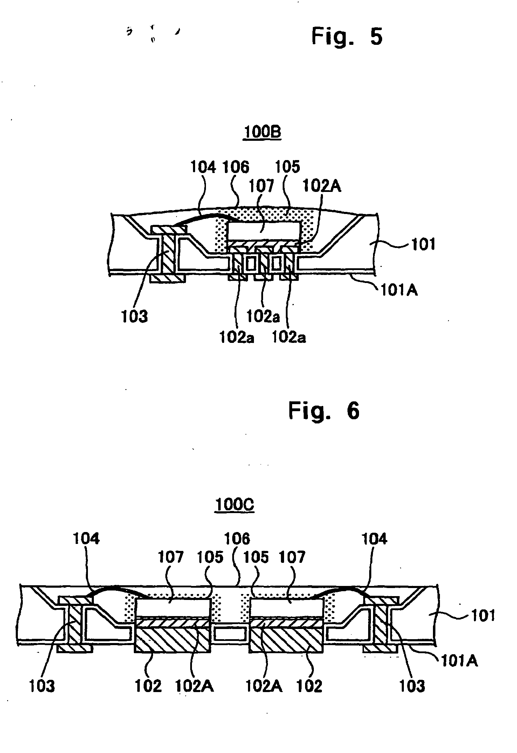

Fig. 5 is a drawing which exemplarily shows a semiconductor device 100B according to a third embodiment of the invention. In the drawing, however, like reference numerals will be given to like portions to those which have already been described above so as to omit the repetition of similar descriptions. In addition, portions about which no particular description will be made have the similar constructions to those of the semiconductor device 100 described in the first embodiment and provide the same advantages provided thereby.

Referring to Fig. 5, in a semiconductor device 100B according to this embodiment, three through electrodes 102a, which each corresponds to the through electrode 102 of the semiconductor device 100, are formed. In this way, the through electrode which is connected with the light emitting element 107 may be provided two or more.

Fig. 6 is a drawing which exemplarily shows a semiconductor device 100C according to a fourth embodiment of the invention. In the drawing, however, like reference numerals will be given to like portions to those which have already been described above so as to omit the repetition of similar descriptions. In addition, portions about which no particular description will be made have the similar constructions to those of the semiconductor device 100 described in the first embodiment and provide the same advantages provided thereby.

Referring to Fig. 6, in a semiconductor device 100C according to this embodiment, a plurality of (two) light emitting elements 107 each corresponding to the light emitting element 107 in the first embodiment are mounted in a recessed portion formed on a substrate 101. In addition, in association with the increase in the number of light emitting elements in that way, pluralities of (two each) through holes 102, 103, connection layers 102A and wires 104 are formed which each correspond to the through electrodes 102, 103, the connection layer 102A and the wire 104 in the first embodiment, respectively. In this way, a configuration may be adopted in which the plurality of light emitting elements are mounted in the recessed portion (cavity) on the substrate. In this embodiment, the number of the light emitting elements mounted on the recessed portion of the substrate is two; however, in order to increase the light intensity of the semiconductor device, for example, four or eight light emitting elements may be arranged on the recessed portion in inline or matrix array.

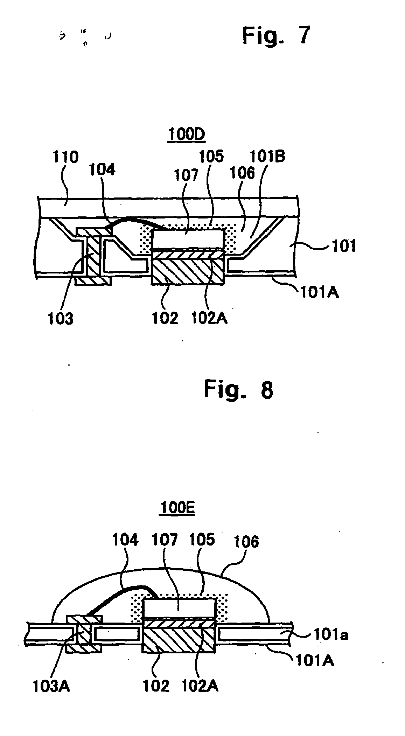

Fig. 7 is a drawing which exemplarily shows a semiconductor device 100D according to a fifth embodiment of the invention. In the drawing, however, like reference numerals will be given to like portions to those which have already been described above so as to omit the repetition of similar descriptions. In addition, portions about which no particular description will be made have the similar constructions to those of the semiconductor device 100 described in the first embodiment and provide the same advantages provided thereby.

Referring to Fig. 7, in a semiconductor device 100D according to this embodiment, a flat plate-like cover 110 is placed in such a manner as to be joined to the perimeter of a recessed portion 101B which corresponds to the recessed portion 101B in the first embodiment. The effect of deterioration of a resin layer 106 due to the layer being exposed to the atmosphere can be reduced by placing the cover 110 in that way.

In addition, with the cover made of glass and the substrate 101 of a silicon, the cover 110 and the substrate 101 can preferably be joined together by virtue of anode bonding.

Additionally, a resin layer which contains a fluorescent material can also be coated on an inner wall surface (a side which faces the light emitting element 107) of the cover 110. As this occurs, the uniformity of the fluorescent material (resin) is improved, whereby there is provided an advantage that variation in luminescence is decreased. In this case, a construction can be adopted in which the resin 105 and the resin layer 106 are omitted, thereby making it possible to increase the heat dissipating performance of the light emitting element.

Fig. 8 is a drawing which exemplarily shows a semiconductor device 100E according to a sixth embodiment of the invention. In the drawing, however, like reference numerals will be given to like portions to those which have already been described above so as to omit the repetition of similar descriptions. In addition, portions about which no particular description will be made have the similar constructions to those of the semiconductor device 100 described in the first embodiment and provide the same advantages provided thereby.

Referring to Fig. 8, in a semiconductor device 100E according to this embodiment, no recessed portion (cavity) is formed on a substrate 101a which corresponds to the substrate 101 of the first embodiment. Because of this, in the semiconductor device 101E according to this embodiment, the working of the substrate is simplified which is required as part of the fabrication of the semiconductor device, and this provides the construction which can suppress the fabrication costs.

In addition, in this embodiment, since no recessed portion is formed, the length of a through electrode 103A, which corresponds to the through electrode 103 of the first embodiment, is shortened, compared to the length of the corresponding electrode of the first embodiment, and hence, the length of the through electrode 103A is made substantially the same as that of a through electrode 102, which corresponds to the through electrode 102 of the first embodiment.

Because of this, in the construction described above, when forming the through electrode 103A and the through electrode 102 by virtue of a plating process, complicated work such as work of masking via holes and work of forming the respective through electrodes in separate steps becomes unnecessary, and hence, the through electrode 103A and the through electrode 102 can be formed simultaneously. In this embodiment, the number of the light emitting element mounted on the substrate is one; however, in order to increase the light intensity of the semiconductor device, a plurality of light emitting elements may be arranged on the substrate, for example, in inline or matrix array.

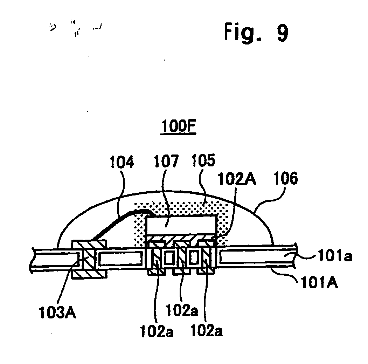

Fig. 9 is a drawing which exemplarily shows a semiconductor device 100F according to a seventh embodiment of the invention. In the drawing, however, like reference numerals will be given to like portions to those which have already been described above so as to omit the repetition of similar descriptions. In addition, portions about which no particular description will be made have the similar constructions to those of the semiconductor device 100 described in the first embodiment and provide the same advantages provided thereby.

Referring to Fig. 9, in a semiconductor device 100F according to this embodiment, as with the sixth embodiment, no recessed portion (cavity) is formed on a substrate 101a which corresponds to the substrate 101 of the first embodiment. Furthermore, in the semiconductor device 100F according to this embodiment, three through electrodes 102a, which each correspond to the through electrode 102 of the semiconductor device 100, are formed. In this way, the through electrode that is connected to the light emitting element 107 may be formed two or more.

In addition, the through electrode 103A and the three through electrodes 102a have substantially the same length.

Because of this, in the construction described above, when forming the through electrode 103A and the through electrodes 102a through a plating process, complicated work such as work of masking via holes and work of forming the respective through electrodes in separate steps becomes unnecessary, and hence, the through electrode 103A and the (three) through electrodes 102a can easily be formed simultaneously.

In addition, the numbers and arrangements of the through electrodes and wires or light emitting elements are not limited to those of the embodiments that have been described heretofore and it is obvious to those skilled in the art that they can be changed or modified variously.

Thus, while the invention has been described with respect to the preferred embodiments, the invention is not such as to be limited to the specific embodiments but can be changed or modified variously without departing from the spirit and scope of the invention described under the claims of the invention.

According to the invention, it becomes possible to provide the semiconductor device having the light emitting element mounted thereon which can be miniaturized and which has superior reliability and the semiconductor fabrication method for fabricating the semiconductor device.

## Claims

1. A semiconductor device comprising:
a substrate (101, 101a);
a light emitting element (107) mounted on the substrate;
a bonding wire (104) connected to the light emitting element; and
a through electrode (103; 103A) connected to the bonding wire and is formed in such a manner as to pass through the substrate.

2. The semiconductor device as set forth in Claim 1, wherein the through electrode is formed in such a manner as to pass through the substrate at a position lying directly below a connecting portion with the bonding wire.

3. The semiconductor device as set forth in Claim 1 or 2, wherein the light emitting element (107) includes an LED, the LED being covered with a resin (105) which contains a fluorescent material.

4. The semiconductor device as set forth in any of Claims 1 to 3, wherein the substrate (101, 101a) is made of a silicon.

5. The semiconductor device as set forth in any of Claims 1 to 4, wherein the bonding wire (104) and the through electrode (103) provided number two or more.

6. The semiconductor device as set forth in any of Claims 1 to 5, further comprising:
an additional through electrode (102, 102a) which is connected to the light emitting element (107) on an opposite side to a side where the bonding wire is connected and is formed in such a manner as to pass through the substrate at a position lying directly below the light emitting element.

7. The semiconductor device as set forth in Claim 6, wherein the additional through electrode formed numbers two or more.

8. The semiconductor device as set forth in Claim 7, wherein the lengths of the through electrode and the additional through electrodes are the same.

9. The semiconductor device as set forth in any of Claims 1 to 8, wherein the light emitting element (107) is mounted in a recessed portion (101B) which is formed on the substrate (101, 101a).

10. The semiconductor device as set forth in Claim 9, having a flat plate-like cover (110) which is joined to a perimeter of the recessed portion.

11. The semiconductor device as set forth in any of Claims 1 to 10, wherein the light emitting element provided numbers two or more.

12. A method for fabricating a semiconductor device in which a light emitting element (107) is mounted on a substrate (101, 101a), comprising:
an electrode forming step of forming a through electrode (103; 103A) which passes through the substrate;
a placing step of placing the light emitting element on the substrate; and
a wiring step for connecting the light emitting element with a side of the through electrode which corresponds to the light emitting element through wire bonding.
